# EUROPEAN PATENT APPLICATION

(11) **EP 4 646 066 A1**
(43) Date of publication of application: **05.11.2025**
(21) Application number: 25168525.1
(22) Date of filing: 04.04.2025
(51) Int. Cl.: H10F 19/90, H10F 77/20

(54) **PHOTOVOLTAIC MODULE AND GLUE PRINTING MESH**

(30) Priority: 25.04.2024 CN 202410509217; 25.04.2024 CN 202410510574
(71) Applicant: JINKO SOLAR CO., LTD, ShangRao, Jiangxi 334100 (CN); Jinko Solar (Haining) Co., Ltd., Haining City, Zhejiang 314415 (CN)
(72) Inventor: TAO, Wusong, JIANGXI (CN); SHI, Jiale, JIANGXI (CN); PENG, Yingying, JIANGXI (CN); WANG, Luchuang, JIANGXI (CN); JIN, Peng, JIANGXI (CN)
(74) Representative: Algemeen Octrooi- en Merkenbureau B.V.

(57) **Abstract**

The present disclosure relates to a photovoltaic module and a glue printing mesh. The photovoltaic module includes a solar cell string. The solar cell string includes solar cells, solder strips, and glue dots. Adjacent solar cells are electrically connected to each other through the solder strips. The solar cells and the solder strips are soldered and fixed at solder points, and the solar cells and the solder strips are bonded and fixed at the glue dots. The solder points includes a first solder point and a second solder point. At least one glue dot is located between the first solder point and the second solder point. A plurality of glue dots are arranged along a first direction. At least two glue dots on adjacent solder strips are not aligned with each other in the second direction. When relative positions of a glue printing device and the solar cell in the first direction deviate from each other, on one finger, a risk that all glue printing positions are away from positions where the solder strips are in contact with the finger is reduced, and a risk of failure of all electrical connections between the finger and all the solder strips is reduced, so as to improve operational stability of the solar cell and the photovoltaic module.

## Description

### TECHNICAL FIELD

The present disclosure relates to the technical field of photovoltaic cells, and in particular, to a photovoltaic module and a glue printing mesh.

### BACKGROUND

A photovoltaic module includes a solar cell string. The solar cell string is formed by connecting a plurality of solar cells in series or in parallel. A plurality of fingers are provided at a surface of the solar cell. When the solar cells are busbar-free solar cells, fingers of adjacent solar cells are connected to each other by a solder strip. In a processing process of the solar cell string, the solder strip needs to be pre-fixed at the surfaces of the solar cells at preset solder points through a soldering process, then glue is applied at preset glue dots through a glue printing process, and after the glue is cured, the solder strips and the solar cells are fixed.

Generally, the glue dots on the solar cells may be evenly arranged in a length direction and a width direction of the solar cells. That is, the glue dots are aligned one by one in the length direction of the solar cells, and the glue dots are also aligned one by one in the width direction of the solar cells. During the glue printing process of the solar cell, if relative positions of the solar cells and a glue printing device deviate from each other, actual printing positions of the glue may deviate from all preset glue dots, thus there is a risk of separation of the solder strip from the fingers due to bending deformation of the solder strip. Compared with the preset glue dots, since the printing positions of the glue all deviate, thus there is a risk that one or a few fingers may be separated from all the solder strip, to affect the output power of the photovoltaic module.

### SUMMARY

The present disclosure provides a photovoltaic module and a glue printing mesh, which can reduce a risk of failure of electrical connection between the solder strip and the finger.

In a first aspect, the present disclosure provides a photovoltaic module, including at least one solar cell string, and one of the solar cell string includes solar cells, solder strips, and glue dots. Adjacent solar cells are electrically connected to each other through the solder strips, the solder strips each extend along a first direction, the solder strips are arranged at intervals along a second direction, the solar cells are provided with solder points, the solar cells and the solder strips are soldered and fixed at the solder points, a part of at least one of the glue dots is located on a surface of one of the solar cells and another part of the at least one of the glue dots is located on a surface of one of the solder strips, in such a manner that the solar cells and the solder strips are bonded and fixed at the glue dots, and a plurality of glue dots of the glue dots are arranged along the first direction. The solder points include a first solder point and a second solder point, and along the first direction, the first solder point and the second solder point are located on two sides of one of the solar cells, and at least one of the glue dots is located between the first solder point and the second solder point. The solder strips include at least a first solder strip and a second solder strip arranged along the second direction, and at least one of the glue dots on the first solder strip is not aligned with at least one of the glue dots on the second solder strip in the second direction.

In the present disclosure, at least one of the glue dots on the first solder strip is not aligned with at least one of the glue dots on the second solder strip in the second direction Y, so that when relative positions of a glue printing device and the solar cell in the first direction deviate from each other, due to the misalignment of the glue dots, on one finger, one part of glue printing positions are farther away from positions where the solder strips are in contact with the finger, and another part of glue printing positions are closer to positions where the solder strips are in contact with the finger, thereby reducing a risk that all glue printing positions are away from the positions where the solder strips are in contact with the finger, and reducing a risk of failure of all electrical connections between the finger and all the solder strips, so as to improve operational stability of the solar cell and the photovoltaic module.

In a possible design, the first solder points on adjacent solder strips are directly opposite to each other in the second direction, and the second solder points on adjacent solder strips are directly opposite to each other in the second direction.

In a possible design, the glue dots include at least a first glue dot, a second glue dot, and third glue dots. In the first direction, the third glue dots are arranged at intervals and located between the first glue dot and the second glue dot. In the first direction, the first glue dot is located at a side of the first solder point facing away from the second solder point, or the first glue dot is located between the first solder point and the second solder point, or in a third direction, at least part of the first glue dot is located above the first solder point; and/or in the first direction, the second glue dot is located at a side of the second solder point facing away from the first solder point, or the second glue dot is located between the first solder point and the second solder point, or in the third direction, at least part of the second glue dot is located above the second solder point.

In a possible design, the first glue dot on the first solder strip is directly opposite to the first glue dot on the second solder strip in the second direction, and/or the second glue dot on the first solder strip is directly opposite to the second glue dot on the second solder strip in the second direction; and the third glue dots on the first solder strip are not aligned with the third glue dots on the second solder strip in the second direction.

In a possible design, along the first direction, the third glue dots are evenly arranged between the first glue dot and the second glue dot, and a number N1 of the third glue dots arranged in the first direction satisfies 4≤N1≤21.

In a possible design, a length of the first glue dot in the first direction ranges from 6 mm to 9 mm, and/or a length of the second glue dot in the first direction ranges from 6 mm to 9 mm.

In a possible design, the glue dots further include a fourth glue dot, and in the first direction, the fourth glue dot is located between the first glue dot and the second glue dot, and the third glue dots are located between the fourth glue dot and the second glue dot; a length of the first glue dot in the first direction ranges from 0.2 mm to 0.4 mm, a length of the fourth glue dot in the first direction ranges from 0.2 mm to 0.4 mm, and a distance between the first glue dot and the fourth glue dot in the first direction ranges from 6 mm to 9 mm; and/or the glue dots further include a fifth glue dot, and in the first direction, the fifth glue dot is located between the first glue dot and the second glue dot, and the third glue dots are located between the first glue dot and the fifth glue dot; and a length of the second glue dot in the first direction ranges from 0.2 mm to 0.4 mm, a length of the fifth glue dot in the first direction ranges from 0.2 mm to 0.4 mm, and a distance between the second glue dot and the fifth glue dot in the first direction ranges from 6 mm to 9 mm.

In a possible design, a number N2 of the solder strips arranged in the second direction satisfies 14≤N2≤16; in the first direction, a distance S1 between the first solder point and an edge of the solar cell satisfies 7 mm≤S1≤8 mm; in the second direction, a distance S2 between the first solder point and an edge of the solar cell satisfies 7 mm≤S2≤8 mm; and/or in the first direction, a distance S3 between the second solder point and an edge of the solar cell satisfies 7 mm≤S3≤8 mm; and in the second direction, a distance S4 between the second solder point and an edge of the solar cell satisfies 7 mm≤S4≤8 mm.

In a possible design, in the first direction, the first glue dot is located at a side of the first solder point facing away from the second solder point, or the first glue dot is located between the first solder point and the second solder point, and a distance S5 between the first glue dot and the first solder point satisfies 1 mm≤S5≤2 mm; and/or in the first direction, the second glue dot is located at a side of the second solder point facing away from the first solder point, or the second glue dot is located between the first solder point and the second solder point, and a distance S6 between the second glue dot and the second solder point satisfies 1 mm≤S6≤2 mm.

In a second aspect, the present disclosure provides a glue printing mesh. The glue printing mesh includes: an outer frame; a mesh body arranged at an edge of the mesh body and including a connection region and a glue printing region, the connection region surrounding an outer side of the glue printing region, and the connection region being fixedly connected to the outer frame; mesh holes provided in the glue printing region and running through the mesh body along a thickness direction of the glue printing mesh. The mesh holes are arranged along the first direction to form unit rows, the unit rows include at least a first unit row and a second unit row, and the first unit row and the second unit row are alternately arranged at intervals along the second direction; and at least one of the mesh holes in the first unit row is not aligned with at least one of the mesh holes in the second unit row in the second direction.

In a possible design, the mesh holes include at least a first hole channel, a second hole channel, and third hole channels. In the first direction, the first hole channel and the second hole channel are located at two ends of the unit row, the third hole channels are arranged at intervals and located between the first hole channel and the second hole channel; the first hole channel in the first unit row is aligned with the first hole channel in the second unit row in the second direction, the second hole channel in the first unit row is aligned with the second hole channel in the second unit row in the second direction, and the third hole channels in the first unit row are not aligned with the third hole channels in the second unit row in the second direction. A number of the third hole channels in the first unit row is N₁, and a number of the third hole channels in the second unit row is N₂, where N₁ and N₂ satisfies N₁-N₂≥1; the third hole channels are evenly distributed between the first hole channel and the second hole channel; and the number N₁ of the third hole channels in the first unit row satisfies 4≤N₁≤21.

In a possible design, the glue printing mesh has a central axis extending along the first direction, and the unit rows are symmetrically distributed about the central axis.

In a possible design, the outer frame includes a first portion and a second portion, and in the first direction, the first portion and the second portion are located at two sides of the mesh body; one unit row of the unit rows includes a first hole channel, a second hole channel, and third hole channels; and in the first direction, the first hole channel is located on a side of the glue printing region close to the first portion, the second hole channel is located on a side of the glue printing region close to the second portion, and the third hole channels are arranged at intervals and located between the first hole channel and the second hole channel; and a length of the first hole channel in the first direction ranges from 6 mm to 9 mm, and/or a length of the second hole channel in the first direction ranges from 6 mm to 9 mm.

In a possible design, the outer frame includes a first portion and a second portion, and in the first direction, the first portion and the second portion are located at two sides of the mesh body; one unit row of the unit rows includes a first hole channel, a second hole channel, and third hole channels; and in the first direction, the first hole channel is located on a side of the glue printing region close to the first portion, the second hole channel is located on a side of the glue printing region close to the second portion, the third hole channels are arranged at intervals and located between the first hole channel and the second hole channel; one unit row of the unit rows further includes a fourth hole channel; in the first direction, the fourth hole channel is located on a side of the glue printing region close to the first portion, the fourth hole channel is located between the first hole channel and the second hole channel, the third hole channels are located between the fourth hole channel and the second hole channel; and a length of the first hole channel in the first direction ranges from 0.2 mm to 0.4 mm, and a length of the fourth hole channel in the first direction ranges from 0.2 mm to 0.4 mm; and/or one unit row of the unit rows further includes a fifth hole channel; in the first direction, the fifth hole channel is located on a side of the glue printing region close to the second portion, the fifth hole channel is located between the first hole channel and the second hole channel, the third hole channels are located between the fifth hole channel and the first hole channel; and a length of the second hole channel in the first direction ranges from 0.2 mm to 0.4 mm, and a length of the fifth hole channel in the first direction ranges from 0.2 mm to 0.4 mm.

In a possible design, a surface of the mesh body in contact with the solar cell is covered by a hydrophobic coating.

In the present disclosure, at least one of the mesh holes in the first unit row is not aligned with at least one of the mesh holes in the second unit row in the first direction, so that when relative positions of the glue printing mesh and the solar cell in the first direction deviate from each other, the glue printing positions on the solder strips deviate from preset positions of glue dots, due to the misalignment of the mesh holes, on one finger, one part of glue printing positions are farther away from positions where the solder strips are in contact with the finger, and another part of glue printing positions are closer to positions where the solder strips are in contact with the finger, thereby reducing a risk that all glue printing positions are away from the positions where the solder strips are in contact with the finger, and reducing a risk of failure of all electrical connections between the finger and all the solder strips, so as to improve operational stability of the solar cell and the photovoltaic module.

It should be understood that the general description above and the detailed description in the following are merely exemplary and illustrative, and cannot limit the present disclosure.

### BRIEF DESCRIPTION OF DRAWINGS

FIG. 1 is a schematic structural diagram of a photovoltaic module according to some embodiments of the present disclosure;
FIG. 2 is a schematic diagram of glue printing positions of a solar cell according to some embodiments of the present disclosure;
FIG. 3 is a schematic diagram of glue printing positions of a solar cell according to some embodiments of the present disclosure;
FIG. 4 is a schematic diagram of a partial structure of a glue printing device according to some embodiments of the present disclosure;
FIG. 5 is a top view of a glue printing mesh in FIG. 4 according to some embodiments;
FIG. 6 is a sectional view of FIG. 5;
FIG. 7 is a top view of a glue printing mesh in FIG. 4 according to some embodiments;
FIG. 8 is a sectional view of FIG. 7;
FIG. 9 is a top view of a glue printing mesh in FIG. 4 according to some embodiments;
FIG. 10 is a sectional view of FIG. 9;
FIG. 11 is a sectional view of a glue printing mesh in FIG. 4 according to some embodiments;
FIG. 12 is a schematic diagram of comparison of surface structures of a magnetron sputtering hydrophobic coating in the present disclosure and a BM coating in the prior art;
FIG. 13 is a schematic diagram of a partial structure of a glue printing device according to some embodiments of the present disclosure; and
FIG. 14 is a top view of a glue printing mesh in FIG. 13 according to some embodiments.

Reference signs:
100: first cover plate;
200: first adhesive film;
300: solar cell string;
400: second adhesive film;
500: second cover plate;
10: solar cell;
   101: finger;
20: solder strip;
30: solder point;
   301: first solder point;
   302: second solder point;
40: outer frame;
   401: first portion;
      401A: first surface;
   402: second portion;
      402A: second surface;
50: connection adhesive;
60: glue dot;
   601: first glue dot;
   602: second glue dot;
   603: third glue dot;
   604: fourth glue dot;
   605: fifth glue dot;
70: base;
80: glue printing mesh;
90: scraper;
   901: first scraper;
   902: second scraper;
1: mesh body;
   11: connection region;
      111: first region;
      112: second region;
   12: glue printing region;
      121: third surface;
      122: third region;
      123: fourth region;
   13: protruding rib;
      131: fourth surface;
2: mesh hole;
   21: first hole channel;
   22: second hole channel;
   23: third hole channel;
   24: fourth hole channel;
   25: unit row;
      251: first unit row;
      252: second unit row;
   26: fifth hole channel;
3: hydrophobic coating;
4: central axis.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better illustrate the technical solutions of the present disclosure, the embodiments of the present disclosure will be described in detail below with reference to the accompanying drawings.

It should be clear that the described embodiments are only some of rather than all of the embodiments of the present disclosure. Based on the embodiments in the present disclosure, all other embodiments obtained by those of ordinary skill in the art without creative efforts shall fall within a scope of protection of the present disclosure.

The terms used in the embodiments of the present disclosure are only for the purpose of describing specific embodiments and are not intended to limit the present disclosure. As used in the embodiments of the present disclosure and the appended claims, the singular forms of "a/an", "one", and "the" are intended to include plural forms, unless otherwise clearly specified in the context.

It should be understood that the term "and/or" used herein is merely an association relationship describing associated objects, indicating that three relationships may exist. For example, A and/or B indicates that there are three cases: A alone, A and B together, and B alone. In addition, the character "/" herein generally indicates an "or" relationship between the associated objects.

It should be understood that, the terms such as "upper", "lower", "left", "right" and the like are used to indicate positions shown in the drawing, instead of being construed as limitations of the embodiment of the present disclosure. In addition, when an element is described as being "on" or "under" another element in the context, it should be understood that the element can be directly or via an intermediate element located "on" or "under" another element.

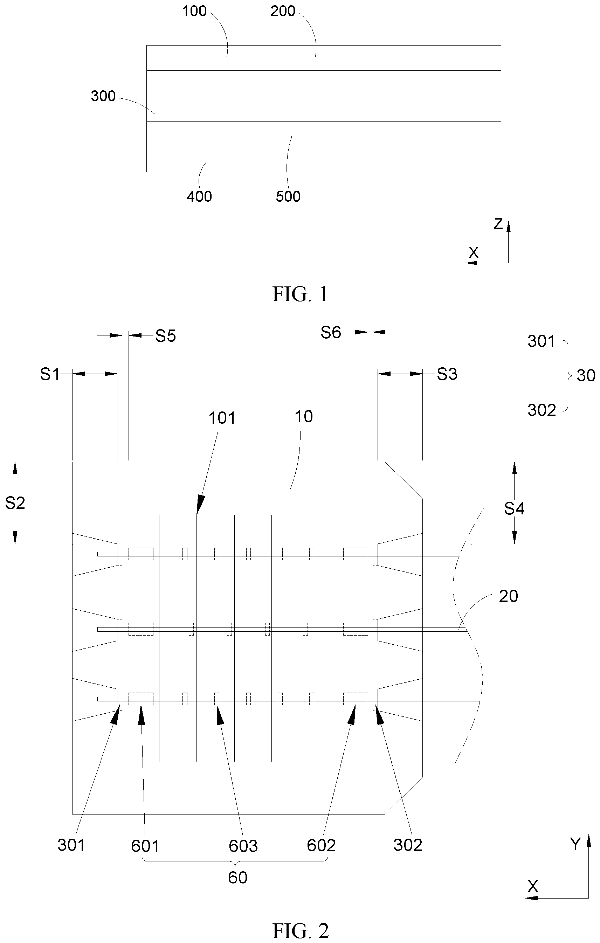

In a first aspect, some embodiments of the present disclosure provide a photovoltaic module. In the technical field of photovoltaic power generation, the photovoltaic module is a core element that converts solar energy into electrical energy. As shown in FIG. 1, the photovoltaic module includes a first cover plate 100, a first adhesive film 200, a solar cell string 300, a second adhesive film 400, and a second cover plate 500 that are stacked along a thickness direction of the photovoltaic module. The first cover plate 100 and the solar cell string 300 are encapsulated and fixed by the first adhesive film 200, and the second cover plate 500 and the solar cell string 300 are encapsulated and fixed by the second adhesive film 400. Other layer may be further provided between the first cover plate 100 and the first adhesive film 200, between the first adhesive film 200 and the solar cell string 300, between the solar cell string 300 and the second adhesive film 400, and between the second adhesive film 400 and the second cover plate 500. A specific number of layers of the photovoltaic module is not limited in the embodiments of the present disclosure.

For a length direction and a width direction of the photovoltaic module, one is defined as a first direction X, and the other is defined as a second direction Y. The thickness direction of the photovoltaic module is defined as a third direction Z. The solar cell string 300 includes a plurality of solar cells 10 arranged along the first direction X and the second direction Y. In the first direction X and the second direction Y, one is a length direction of the solar cell 10, and the other is a width direction of the solar cell 10.

Types of the solar cell 10 are not limited in the embodiments of the present disclosure. The types of the solar cell 10 include, but are not limited to, a passivated emitter rear cell (PERC), a tunnel oxide passivated contact (TOPCon) cell, a heterojunction with intrinsic thin-film (HJT) cell, an interdigitated back contact (IBC) cell, a perovskite cell, and the like.

For the PERC, along a thickness direction thereof, the PERC sequentially includes a front-surface metal silver electrode, a front-surface silicon nitride passivation layer, a phosphor layer emitter, a P-type substrate silicon layer, a local aluminum back field, a metal aluminum back electrode, and a back passivation layer (Al2O3/SiNx). In the PERC, a passivation film is used to passivate the back to replace an all-aluminum back field, which enhances internal back reflection of light on a silicon substrate, reduces a recombination rate on the back, and increases efficiency of the cell by 0.5% to 1%.

For the TOPCon cell, along a thickness direction thereof, the TOPCon cell sequentially includes a metal silver electrode, a front-surface silicon nitride passivation layer, a boron-doped emitter, an N-type substrate silicon layer, a diffusion doping layer, ultra-thin silicon oxide, doped polysilicon, silicon nitride, and a metal silver electrode. The back of the cell is formed by a layer of ultra-thin silicon oxide (1 nm to 2 nm) and a layer of phosphorus-doped microcrystalline amorphous mixed Si film, which jointly form a passivation contact structure. This structure can prevent recombinations of minority carriers and holes, and increase an open-circuit voltage and a short-circuit current of the cell. The ultra-thin oxide layer allows majority carriers and electrons to tunnel into a polysilicon layer and also prevents recombinations of minority carriers and holes. A good passivation effect of the ultra-thin silicon oxide and a heavily doped silicon film causes a surface energy band of a silicon wafer to bend, so as to form a field passivation effect, and a probability of electron tunneling is greatly increased, the contact resistance is decreased, and the open-circuit voltage and the short-circuit current of the cell is increased, thereby improving conversion efficiency of the cell.

For the HJT cell, along a thickness direction thereof, the HJT cell sequentially includes a front low-temperature silver electrode, a front conductive film, an N-type amorphous silicon film, an intrinsic amorphous silicon film, an N-type substrate silicon layer, an intrinsic amorphous silicon film, a P-type amorphous silicon film, a back conductive film, and a back low-temperature silver electrode.

For the IBC cell, along a thickness direction thereof, the IBC cell sequentially includes a silicon nitride anti-layer, an N+ front surface field, an N-type substrate silicon layer, a P+ emitter, an N+ back field, an aluminum oxide passivation layer, a silicon nitride antireflection layer, and a metal silver electrode. The IBC cell can obtain P regions and N regions with good uniformity and precise and controllable junction depths by using an ion implantation technology, and there is no electrode at the front of the solar cell, which can eliminate a blackout current loss of a metal electrode, realize maximum utilization of incident photons, and increase about 7% compared with the short-circuit current of a conventional solar cell. Due to a back contact structure, there is no need to consider the shielding of the electrode, and a proportion of the electrode can be appropriately widened, thereby reducing the series resistance and having a high fill factor. Surface passivation and a surface light trapping structure can be optimally designed, and a lower front surface recombination rate and surface reflection.

For the perovskite cell, along a thickness direction thereof, the perovskite cell sequentially includes a substrate material, a conductive film, an electron transport layer (titanium dioxide), a perovskite absorption layer (hole transport layer), and a metal cathode. A perovskite material has a high light absorption coefficient and a large carrier diffusion distance. After photons absorbed by the perovskite material are converted to be electrons, they are easily collected by the electrodes, and there is little loss. Therefore, high photogenerated voltages and currents can be generated, making perovskite exhibit a higher photoelectric conversion efficiency.

As shown in FIG. 2, the solar cell 10 includes fingers 101 extending along the second direction Y, and a plurality of fingers 101 are arranged at intervals along the first direction X. Solder strips 20 extending along the first direction X are fixed to the solar cell 10, and a plurality of solder strips are arranged at intervals along the second direction Y. The solder strip 20 is electrically connected to at least two fingers 101, and in the first direction X, the solder strip 20 is connected to at least two solar cells 10, to achieve series or parallel connection of adjacent solar cells 10. As shown in FIG. 2, the solar cell is provided with a solder point 30, the solar cell and the solder strip are soldered and fixed to each other at the solder point 30, the solar cell string 300 further includes a plurality of glue dots 60, and one part of at least one glue dot 60 is located at a surface of the solar cell 10 and another part of the at least one glue dot 60 is located at a surface of the solder strip 20, so that the solar cell 10 and the solder strip 20 are bonded and fixed to each other at the glue dot 60. The solder strip 20 is in direct contact with the finger 101, that is, the busbar structure in the prior art is canceled, so that the solar cell 10 is a busbar-free solar cell. During manufacturing of the solar cell 10, the busbar-free solar cell reduces an amount of silver paste, which helps to reduce a printing cost of the solar cell 10 and reduce a shielding area of the surface of the solar cell 10 by the electrode, thereby increasing an area of the solar cell 10 for contact with sunlight and thus helping to improve the photoelectric conversion efficiency of the solar cell 10.

During the manufacturing of the busbar-free solar cell, firstly, the surface of the solar cell 10 is coated with silver paste to form a plurality of fingers 101, and at least one solder point 30 is formed at the same time. Taking two solder points 30 as an example, as shown in FIG. 2, in the first direction X, the two solder points 30 are distributed on two sides of the solar cell 10 to pre-fix a same solder strip 20, and in the second direction Y, a plurality of solder points 30 are distributed at intervals to fix different solder strips 20, respectively. After the formation of the finger 101 and the solder points 30, a plurality of solar cells 10 and the solder strips 20 are soldered in series. Taking one solder strip 20 as an example, on one solar cell 10, the solder strip 20 is fixedly connected to two solder points 30 distributed along the first direction X, and the solder strip 20 is also soldered and fixed to the finger 101, so as to be pre-fixed to the solar cell 10. However, due to a small size of the finger 101, a connection force between the finger 101 and the solder strip 20 is weak, and there is a risk that the solder strip 20 and the finger 101 may be separated from each other during subsequent processing, transportation, mounting, or use. To this end, after the solder strip 20 and the solar cell 10 are pre-fixed, glue is applied to a side of the solder strip 20 facing away from the solar cell 10 at a preset glue dot 60 through the glue printing device, and after the glue is cured, the glue dot 60 is formed. One part of at least one glue dot 60 is located on the surface of the solder strip 20, and the other part of the of at least one glue dot 60 is located on the surface of the solar cell 10, so that the solder strip 20 is bonded and fixed to the surface of the solar cell 10. In addition, alternately, at least one glue dot 60 may be located only on the surface of the solder strip 20, and/or at least one glue dot 60 may be located only on the surface of the solar cell 10.

During the manufacturing, the solder strip and the solar cell are pre-fixed by soldering first, thereby reducing a risk of deviation of the solder strip during the printing, and thus improving accuracy of the position of the solder strip on the solar cell. Then, the solder strip and the solar cell are bonded and fixed by glue, thereby improving stability of the connection between the solder strip and the solar cell, and reducing the risk of separation of the solder strip from the solar cell during subsequent mounting, transportation, or use, and thus improving operational stability of the photovoltaic module and helping to prolong the service life of the photovoltaic module.

As shown in FIG. 2, the solder points 30 include at least a first solder point 301 and a second solder point 302, along the first direction X, the first solder point 301 and the second solder point 302 are located on two sides of the solar cell 10, respectively. Part of the glue dots 60 may be located between the first solder point 301 and the second solder point 302, part of the glue dots 60 may be located at a side of the first solder point 301 facing away from the second solder point 302, and part of the glue dots 60 may be located at a side of the second solder point 302 facing away from the first solder point 301. For example, the glue dots 60 include a first glue dot 601, a second glue dot 602, and a plurality of third glue dots 603 distributed along the first direction X, and the plurality of third glue dots 603 are located between the first glue dot 601 and the second glue dot 602. The first glue dot 601 may be located at a side of the first solder point 301 facing away from the second solder point 302 and have a preset gap from the first solder point 301, or one part of the first glue dot 601 is located at a side of the first solder point 301 facing away from the second solder point 302 and another part of the first glue dot 601 is located above the first solder point 301 in the third direction Z, or one part of the first glue dot 601 is located at a side of the first solder point 301 facing away from the second solder point 302, one part of the first glue dot 601 is located above the first solder point 301 in the third direction Z and another part of the first glue dot 601 is located between the first solder point 301 and the second solder point 302, or one part of the first glue dot 601 is located above the first solder point 301 and another part of the first glue dot 601c is located between the first solder point 301 and the second solder point 302, or the first glue dot 601 is located at a side of the second solder point 302 facing away from the first solder point 301 and has a preset gap from the second solder point 302. Similarly, the second glue dot 602 may also have the above-mentioned five possible positions, which are not described in detail herein. Through the five possible positions of the first glue dot 601 and the second glue dot 602, flexibility of the positions of the first glue dot 601 and the second glue dot 602 can be improved.

For the convenience of description, it is assumed in the following that all the glue dots 60 are located between the first solder point 301 and the second solder point 302. That is, on one solder strip 20, two sides of the solder strip 20 in the first direction X are respectively pre-fixed to the solar cell 10 by the first solder point 301 and the second solder point 302. In the first direction X, the glue dot(s) 60 is arranged between the first solder point 301 and the second solder point 302, to reduce a risk of bending and movement of the solder strip 20 during the glue printing of the solar cell 10.

The first solder points 301 on adjacent solder strips 20 are directly opposite to each other in the second direction Y; and the second solder points 302 on the adjacent solder strips 20 are directly opposite to each other in the second direction Y. During soldering and pre-fixing of the solder strip 20 and the solar cell 10, all the solder strips 20 on one solar cell 10 can be simultaneously pre-fixed to the solar cell 10 at the first solder point 301 and/or the second solder point 302, thereby reducing a risk of deviation of the solder strip 20 during the soldering.

As shown in FIG. 2, along the first direction X, a distance S1 between the first solder point 301 and an edge of the solar cell 10 satisfies 7 mm≤S1≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like; along the second direction Y, a distance S2 between the first solder point 301 and an edge of the solar cell 10 satisfies 7 mm≤S2≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like; and/or along the first direction X, a distance S3 between the second solder point 302 and an edge of the solar cell 10 satisfies 7 mm≤S3≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like; and along the second direction Y, a distance S4 between the second solder point 302 and an edge of the solar cell 10 satisfies 7 mm≤S4≤8 mm, which may be, for example, 7 mm, 7.1 mm, 7.2 mm, 7.3 mm, 7.4 mm, 7.5 mm, 7.6 mm, 7.7 mm, 7.8 mm, 7.9 mm, 8 mm, or the like.

If the distance between the solder point 30 and the edge of the solar cell 10 is less than 7 mm, difficulty of soldering of the solder strip 20 and the solar cell 10 is increased, and precision for soldering of the solder strip 20 and the solar cell 10 is also increased. If the distance between the solder point 30 and the edge of the solar cell 10 is larger than 8 mm, a distance between the first solder point 301 and the second solder point 302 in the first direction X is reduced, thereby reducing a region for arranging the glue dot 60 and affecting a number of the glue dots 60 that can be arranged. Therefore, when the distance between the solder point 30 and the edge of the solar cell 10 ranges from 7 mm to 8 mm, difficulty of and precision for soldering of the solder strip 20 and the solar cell 10 can be reduced, thereby reducing a soldering cost of the solder strip 20 and the solar cell 10 and also increasing the distance between the first solder point 301 and the second solder point 302 in the first direction X, so as to increase the number of the glue dots 60 that can be arranged.

As shown in FIG. 2, the solder strips 20 include at least a first solder strip 20 and a second solder strip 20 arranged along the second direction Y, at least part of the glue dots 60 on the first solder strip 20 are not aligned with at least part of the glue dots 60 on the second solder strip 20 in the second direction Y, so that when relative positions of the glue printing device and the solar cell 10 in the first direction X deviate from each other, the glue printing positions on the solder strips 20 deviate from preset positions of glue dots 60, due to the misalignment of the glue dots 60, on one finger 101, one part of glue printing positions are farther away from positions where the solder strips 20 are in contact with the finger 101, and another part of glue printing positions are closer to positions where the solder strips 20 are in contact with the finger 101, thereby reducing a risk that all glue printing positions are away from the positions where the solder strips 20 are in contact with the finger 101, and reducing a risk of failure of all electrical connections between the finger 101 and all the solder strips 20, so as to improve operational stability of the solar cell 10 and the photovoltaic module.

As shown in FIG. 2, the first glue dot 601 on the first solder strip 20 is directly opposite to the first glue dot 601 on the second solder strip 20 in the second direction Y, and/or the second glue dot 602 on the first solder strip 20 is directly opposite to the second glue dot 602 on the second solder strip 20 in the second direction Y; and the third glue dots 603 on the first solder strip 20 are not aligned with the third glue dots 603 on the second solder strip 20 in the second direction Y.

The glue printing device includes a base configured to support the solar cell 10, a glue printing mesh configured to be pressed on the surface of the solar cell 10, and a scraper. The scraper is configured to press down the glue printing mesh and scrape the glue into the mesh holes formed in the glue printing mesh, so that the glue flows along the mesh holes onto the surfaces of the solar cell 10 and the solder strip 20. The first glue dots 601 on adjacent solder strips 20 are aligned with each other and the second glue dots 602 on the adjacent solder strips 20 are aligned with each other, which helps to improve consistency of forces of the scraper in the second direction Y at an initial position where the scraper presses down the glue printing mesh, thereby helping to reduce difficulty of debugging of a downward pressing force of the scraper.

As shown in FIG. 2, along the first direction X, a plurality of third glue dots 603 are evenly distributed between the first glue dot 601 and the second glue dot 602. If the third glue dots 603 are unevenly distributed, a distance between two adjacent third glue dots 603 is smaller while a distance between another two adjacent third glue dots 603 is larger, in this case, a risk of failure of contact between the solder strip 20 and the finger 101 is higher between the two adjacent third glue dots 603 with the larger distance. Therefore, the even distribution of the third glue dots 603 between the first glue dot 601 and the second glue dot 602 can further reduce the risk of failure of contact between the solder strip 20 and the finger 101, thereby improving operational stability of the solar cell 10 and the photovoltaic module.

A number N1 of the third glue dots 603 in the first direction X satisfies 4≤N1≤21. The number of the third glue dots 603 may be 4, 5, 6, 7, 8, 9, 10, 11, 12, 13, 14, 15, 16, 17, 18, 19, 20, 21, or the like. If the number of the third glue dots 603 on the first solder strip 20 is less than 4, the number of the third glue dots 603 on the second solder strip 20 adjacent thereto may be less, which reduces reliability of bonding between the solder strip 20 and the solar cell 10. If the number of the third glue dots 603 distributed in the first direction X is too many, a glue printing cost of the solar cell 10 is increased. Therefore, when 4≤N1≤21, the glue printing cost of the solar cell 10 can be reduce while the reliability of bonding between the solder strip 20 and the solar cell 10 can be improved.

In a possible design, as shown in FIG. 2, a length of the first glue dot 601 in the first direction X ranges from 6 mm to 9 mm, which may be, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like, and/or a length of the second glue dot 602 in the first direction X ranges from 6 mm to 9 mm, which may be, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like.

When the length of the first glue dot 601 in the first direction X ranges from 6 mm to 9 mm and the length of the second glue dot 602 in the first direction X ranges from 6 mm to 9 mm, difficulty of glue output of the glue printing device at the first glue dot 601 and the second glue dot 602 can be reduced, and an amount of glue at the first glue dot 601 and the second glue dot 602 can be increased, thereby improving stability of bonding between the solder strip 20 and the solar cell 10 at the first glue dot 601 and the second glue dot 602.

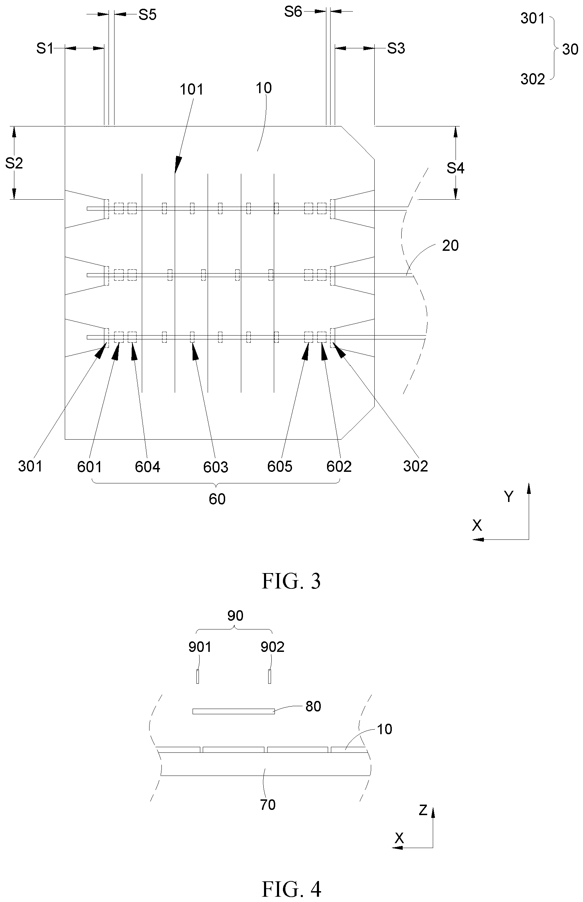

In another possible design, as shown in FIG. 3, the glue dots 60 further include a fourth glue dot 604, and along the first direction X, the fourth glue dot 604 is located between the first glue dot 601 and the second glue dot 602, and the third glue dot 603 is located between the fourth glue dot 604 and the second glue dot 602. A length of the first glue dot 601 in the first direction X ranges from 0.2 mm to 0.4 mm, the length of the first glue dot 601 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; a length of the fourth glue dot 604 in the first direction X ranges from 0.2 mm to 0.4 mm, the length of the fourth glue dot 604 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a distance between the first glue dot 601 and the fourth glue dot 604 in the first direction X ranges from 6 mm to 9 mm. And/or, the glue dots 60 further include a fifth glue dot 605, and along the first direction X, the fifth glue dot 605 is located between the first glue dot 601 and the second glue dot 602, and the third glue dot 603 is located between the first glue dot 601 and the fifth glue dot 605. A length of the second glue dot 602 in the first direction X ranges from 0.2 mm to 0.4 mm, the length of the second glue dot 602 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; a length of the fifth glue dot 605 in the first direction X ranges from 0.2 mm to 0.4 mm, the length in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a distance between the second glue dot 602 and the fifth glue dot 605 in the first direction X ranges from 6 mm to 9 mm. That is, one longer glue dot 60 of 6 mm to 9 mm in the previous design is changed to be two shorter glue dots 60 of 0.2 mm to 0.4 mm, which can reduce the amount of glue without changing the stability of bonding between the solder strip 20 and the solar cell 10, thereby reducing the glue printing cost of the solar cell 10.

As shown in FIG. 2 and FIG. 3, along the first direction X, a distance S5 between the first glue dot 601 and the first solder point 301 satisfies 1 mm≤S5≤2 mm, which may be, for example, 1 mm, 1.1 mm, 1.2 mm, 1.3 mm, 1.4 mm, 1.5 mm, 1.6 mm, 1.7 mm, 1.8 mm, 1.9 mm, 2 mm, or the like; and/or along the first direction X, a distance S6 between the second glue dot 602 and the second solder point 302 satisfies 1 mm≤S6≤2 mm, which may be, for example, 1 mm, 1.1 mm, 1.2 mm, 1.3 mm, 1.4 mm, 1.5 mm, 1.6 mm, 1.7 mm, 1.8 mm, 1.9 mm, 2 mm, or the like.

If the distances from the first glue dot 601 and the second glue dot 602 to the solder point 30 are smaller, there is a risk of local thickening of the solar cell 10 caused by part of the first glue dot 601 and the second glue dot 602 being located above the solder point 30, thereby increasing a risk of damage to the solar cell 10 at the first glue dot 601, the second glue dot 602, and the solder point 30. If the distances from the first glue dot 601 and the second glue dot 602 to the solder point 30 are larger, a region between the first glue dot 601 and the second glue dot 602 used to arrange the third glue dot 603 is reduced, which affects the number of the third glue dot(s) 603 that can be arranged. Therefore, when the distance from the first glue dot 601 to the solder point 30 and the distance from the second glue dot 602 to the solder point 30 each range from 1 mm to 2 mm, a risk of damage to the solar cell 10 at the first glue dot 601, the second glue dot 602, and the solder point 30 is reduced, and it is conducive to increasing the number of the third glue dot(s) 603 that can be arranged.

In any one of the embodiments described above, a length of the third solder point 30 in the first direction X ranges from 5 mm to 20 mm, which may be, for example, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or the like.

In any one of the embodiments described above, a number N2 of the solder strips 20 in the second direction Y satisfies 14≤N2≤16, and the first solder strip 20 and the second solder strip 20 are alternately arranged at intervals in the second direction Y. The number of the solder strips 20 may be 14, 15, or 16. If more solder strips 20 are arranged, a distance between adjacent solder strips 20 is smaller, then there is a risk of short circuit of the solar cell 10 caused by contact between adjacent solder strips 20, and more solder strips 20 also increase shielding of the surface of the solar cell 10, thereby affecting conversion efficiency of the solar cell 10. If less solder strips 20 are arranged, the solder strips 20 have low current transfer efficiency, resulting in low output power of the photovoltaic module. Therefore, when the number of the solder strips 20 ranges from 14 to 16, a risk of short circuit of the solar cell 10 caused by contact between adjacent solder strips 20 is reduced, operational stability of the solar cell 10 is improved, and it is conducive to increasing a light-receiving area of the solar cell 10, thereby helping to improve photoelectric conversion efficiency of the solar cell 10. In addition, current transfer efficiency of the solder strip 20 is improved, thereby increasing output power of the photovoltaic module.

The first solder strips 20 are symmetrically distributed about an axis extending along the first direction X on the solar cell 10, and the second solder strips 20 are symmetrically distributed about the axis extending along the first direction X on the solar cell 10, so that when the scraper presses down during glue printing of the solar cell 10 by the glue printing device, a glue printing mesh body is evenly stressed on two sides of the second direction Y.

In addition, two surfaces of the solar cell 10 opposite to each other along the third direction Z need to be bonded and fixed to the solder strips 20, respectively. For example, a light-facing surface of the solar cell 10 is provided with the first solder strip 20 and the second solder strip 20 adjacent to each other, and a backlight surface is provided with a third solder strip 20 and a fourth solder strip 20 adjacent to each other. In the third direction Z, the first solder strip 20 is located above the third solder strip 20, and the second solder strip 20 is located above the fourth solder strip 20, in this case, the third glue dots 603 on the first solder strip 20 and the third glue dots 603 on the third solder strip 20 are not aligned in the second direction Y, and the third glue dots 603 on the second solder strip 20 and the third glue dots 603 on the fourth solder strip 20 are not aligned in the second direction Y.

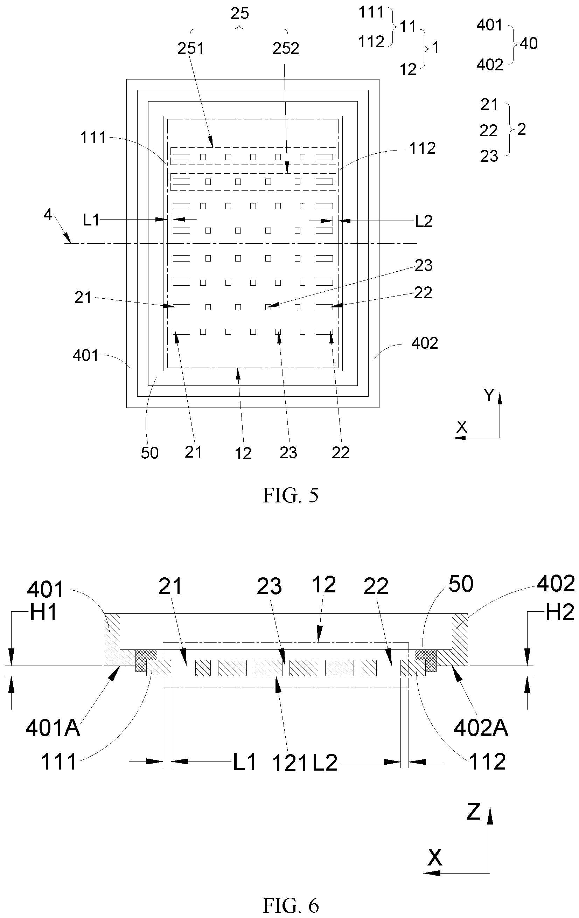

Based on the photovoltaic module in any one of the embodiments described above, in a second aspect, some embodiments of the present disclosure provide a glue printing device. As shown in FIG. 4, the glue printing device includes a base 70, a glue printing mesh 80, and a scraper 90. The base 70 is configured to support the solar cell 10. The solar cell 10 and the glue printing mesh 80 are arranged along the third direction Z. As shown in FIG. 5, the glue printing mesh 80 includes a mesh body 1 and an outer frame 40 arranged on the mesh body 1. The outer frame 40 is fixedly connected to the base 70. Along a thickness direction of the glue printing mesh 80, i.e., along the third direction Z, a scraper 90 is arranged at a side of the glue printing mesh 80 facing away from the solar cell 10. The scraper 90 is configured to press down the mesh body 1 along the thickness direction Z of the glue printing mesh 80 and configured to scrape the glue of the glue printing mesh 80 into the mesh holes 2. The mesh holes 2 are in one-to-one correspondence to the glue dots 60 on the solar cell 10. As shown in FIG. 4, the scraper 90 includes a first scraper 901 and a second scraper 902 arranged along the first direction X. The first scraper 901 and the second scraper 902 operate alternately.

As shown in FIG. 4, a plurality of solar cells 10 and solder strips 20 are pre-soldered through the solder points 30 and then placed on the base 70. In this case, a plurality of solar cells 10 are distributed at intervals along the first direction X, and in the third direction Z, the glue printing mesh 80 is located directly above the first solar cell 10. Afterwards, the glue printing mesh 80 is driven to move along the third direction Z towards the solar cell 10 until the glue printing mesh 80 abuts against the solar cell 10, and then the first scraper 901 is driven to move along the third direction Z towards the glue printing mesh 80. The first scraper 901 abuts against the mesh body 1 and presses down the mesh body 1, so that interaction forces along the third direction Z exist between the first scraper 901 and the mesh body 1 and between the mesh body 1 and the solar cell 10. Afterwards, the first scraper 901 moves along the first direction X. A movement direction of the first scraper 901 may be either a positive direction of the first direction X, i.e., a direction pointed by the arrow of the first direction X shown in FIG. 4, or a negative direction of the first direction X, i.e., a direction opposite to the direction pointed by the arrow of the first direction X shown in FIG. 4. For example, the first scraper 901 moves along the negative direction of the first direction X, a side of the mesh body 1 facing away from the solar cell 10 is provided with glue, and with the movement of the first scraper 901, the glue is pushed to the mesh holes 2 formed in the mesh body 1 and then flows through the mesh holes 2 to reach the surfaces of the solder strip 20 and the first solar cell 10. After completing a scraping stroke, the first scraper 901 may move along the third direction Z and towards a direction facing away from the glue printing mesh 80 and the glue printing mesh 80 may move along the third direction Z and towards a direction facing away from the solar cell 10, so that the glue printing mesh 80 is separated from the solar cell 10 and the first scraper 901 is separated from the glue printing mesh 80. At the same time, the base 70 drives the solar cell 10 to move along the first direction X, so that the first solar cell 10 that has been coated with the glue moves to a curing station to facilitate curing of the glue. When the second solar cell 10 is directly opposite to the glue printing mesh 80 in the third direction Z, the glue printing mesh 80 is pressed down again, and the second scraper 902 presses down and moves along the positive direction of the first direction X, so that glue flows through the mesh holes 2 to reach the surfaces of the solder strip 20 and the second solar cell 10. The glue printing device performs cyclic reciprocating motion according to the above-described processes, to realize a glue printing operation on the third solar cell 10, the fourth solar cell 10, and other more solar cells 10.

Through the arrangement of the first scraper 901 and the second scraper 902, the waiting time between two glue printing operations of the glue printing device is reduced, thereby improving the glue printing efficiency of the glue printing device.

As shown in FIG. 5 and FIG. 6, the glue printing mesh 80 includes an outer frame 40, a mesh body 1, and mesh holes 2. The mesh body 1 includes a connection region 11 and a glue printing region 12. The glue is applied to a surface at a side of the glue printing region 12 facing away from the solar cell 10. The connection region 11 surrounds an outer side of the glue printing region 12. The outer frame 40 is arranged at an edge of the connection region 11, and the outer frame 40 is bonded and fixed to the edge of the connection region 11 through a connection adhesive 50. In the first direction X and the second direction Y, part of the connection adhesive 50 is located between the outer frame 40 and the edge of the connection region 11; and in the third direction Z, part of the connection adhesive 50 overflows onto the surface at a side of the connection region 11 facing away from the solar cell 10. A plurality of mesh holes 2 are arranged along the first direction X to form a unit row 25. A plurality of unit rows 25 are arranged along the second direction Y. Adjacent unit rows 25 are respectively defined as a first unit row 251 and a second unit row 252. For example, the first unit row 251 is located above the first solder strip, and the second unit row 252 is located above the second solder strip.

As shown in FIG. 5, the mesh holes 2 include at least a first hole channel 21, a second hole channel 22, and third hole channels 23. The first hole channel 21 corresponds to the first glue dot 601 on the solar cell 10, the second hole channel 22 corresponds to the second glue dot 602 on the solar cell 10, and the third hole channels 23 correspond to the third glue dots 603 on the solar cell 10. In the same distribution form as the first glue dot 601, the second glue dot 602, and the third glue dot 603, along the first direction X, the third hole channels 23 are located between the first hole channel 21 and the second hole channel 22, and the third hole channels 23 are arranged at intervals along the first direction X. The first hole channel 21 in the first unit row 251 is aligned with the first hole channel 21 in the second unit row 252 in the second direction Y, the second hole channel 22 in the first unit row 251 is aligned with the second hole channel 22 in the second unit row 252 in the second direction Y, and the third hole channel 23 in the first unit row 251 is not aligned with the third hole channel 23 in the second unit row 252 in the second direction Y.

The first hole channels 21 in adjacent unit rows 25 are aligned and the second hole channels 22 in the adjacent unit rows 25 are aligned, so that two ends of adjacent unit rows 25 are aligned and lengths of adjacent unit rows 25 in the first direction X are consistent, which reduces a risk of a larger required glue printing region 12 caused by a larger deviation in length dimensions of adj acent unit rows 25, thereby helping to reduce an overall dimension of the glue printing mesh 80. At the same time, at an initial position where the scraper 90 presses down the mesh body 1, it is conducive to improving consistency of forces of the scraper 90 in the second direction Y, thereby helping to reduce difficulty of debugging of the downward pressing force of the scraper 90.

Along the first direction X, a plurality of third hole channels 23 are evenly distributed between the first hole channel 21 and the second hole channel 22. If the third hole channels 23 are unevenly distributed, a distance between two adjacent third hole channels 23 is smaller while a distance between two other adjacent third hole channels 23 is larger, in this case, between the two third hole channels 23 with a larger distance, a risk of failure of contact between the solder strip 20 and the finger 101 is higher. Therefore, even distribution of the third hole channels between the first hole channel 21 and the second hole channel 22 can further reduce a risk of failure of contact between the solder strip 20 and the finger 101, thereby improving operational stability of the solar cell 10 and the photovoltaic module.

A number of the third hole channels 23 in the first unit row 251 is N1, a number of the third hole channels 23 in the second unit row 252 is N2, and N1 and N2 satisfies N1-N2≥1, so that numbers of the mesh holes 2 in adjacent unit rows 25 are different, which can reduce a total number of the mesh holes 2 required, can improve structural strength of the mesh body 1 and prolong a service life of the mesh body 1 on the one hand, and can further reduce an amount of glue printing on the other hand, thereby reducing the glue printing cost of the solar cell 10.

The number N₁ of the third hole channels 23 in the first unit row 251 satisfies 4≤N₁. The number of the third hole channels 23 may be, for example, 4, 5, 6, 7, 8, 9, 10, 11, 12, 13, 14, or more. If the number of the third hole channels 23 in the first unit row 251 is less than 4, there may be less third hole channels 23 in the second unit row 252 adjacent thereto, which may reduce the positions of the glue dots 60 for bonding the solder strip 20 and the solar cell 10, thereby reducing reliability of the bonding between the solder strip 20 and the solar cell 10. Therefore, when 4≤N₁, the positions of the glue dots 60 for bonding the solder strip 20 and the solar cell 10 can be increased, thereby improving the reliability of the bonding between the solder strip 20 and the solar cell 10.

For example, the number N₁ of the third hole channels 23 in the first unit row 251 satisfies N₁≤21. That is, the number of the third hole channels 23 in the first unit row 251 ranges from 4 to 21. If there are more third hole channels 23, structural strength of the mesh body 1 is weak. In this case, when the scraper 90 presses down, there is a risk of breakage of the mesh body 1; in addition, the number of the glue dots 60 on the surface of the solar cell 10 is also increased, thereby increasing the glue printing cost of the solar cell 10. Therefore, when N₁≤21, the structural strength of the mesh body 1 is improved, the service life of the mesh body 1 is prolonged, and the number of the glue dots 60 is reduced, thereby reducing the glue printing cost of the solar cell 10.

And/or, the number of the third hole channels 23 in the second unit row 252 ranges from 4 to 21.

As shown in FIG. 5, the glue printing mesh 80 includes a central axis 4 extending along the first direction X, a plurality of unit rows 25 are symmetrically distributed about the central axis 4, and when the scraper 90 presses down, the mesh body 1 is evenly stressed at two sides of the second direction Y.

Two surfaces of the solar cell 10 opposite to each other along the third direction Z are required to be bonded and fixed to the solder strip 20, respectively. For example, a light-facing surface of the solar cell 10 is provided with the first unit row 251 and the second unit row 252 adjacent to each other, and a backlight surface of the solar cell 10 is provided with a third unit row and a fourth unit row adjacent to each other. In the third direction Z, the first unit row 251 is located above the third unit row, and the second unit row 252 is located above the fourth unit row, in this case, part of the mesh holes 2 in the first unit row 251 and part of the mesh holes 2 in the third unit row are not aligned in the second direction Y, and part of the mesh holes 2 in the second unit row 252 and part of the mesh holes 2 in the fourth unit row are not aligned in the second direction Y.

As shown in FIG. 5, the outer frame 40 includes a first portion 401 and a second portion 402, and along the first direction X, the first portion 401 and the second portion 402 are located on two sides of the mesh body 1. The connection region 11 includes a first region 111 and a second region 112, the first region 111 is bonded and fixed to the first portion 401, and the second region 112 is bonded and fixed to the second portion 402. Along the first direction X, the first hole channel 21 is located on a side of the glue printing region 12 close to the first portion 401, the second hole channel 22 is located on a side of the glue printing region 12 close to the second portion 402, the third hole channels 23 are located between the first hole channel 21 and the second hole channel 22, and a plurality of third hole channels 23 are arranged at intervals along the first direction X.

In a possible design, as shown in FIG. 5, a length of the first hole channel 21 in the first direction X ranges from 6 mm to 9 mm, which may be, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like, and/or a length of the second hole channel 22 in the first direction X ranges from 6 mm to 9 mm, which may be, for example, 6 mm, 6.1 mm, 6.3 mm, 6.5 mm, 6.7 mm, 6.9 mm, 7 mm, 7.1 mm, 7.3 mm, 7.5 mm, 7.7 mm, 7.9 mm, 8 mm, 8.1 mm, 8.3 mm, 8.5 mm, 8.7 mm, 8.9 mm, 9 mm, or the like. When the length of the first hole channel 21 in the first direction X ranges from 6 mm to 9 mm and the length of the second hole channel 22 in the first direction X ranges from 6 mm to 9 mm, difficulty of glue output at the first hole channel 21 and the second hole channel 22 can be reduced, and an amount of glue at the first hole channel 21 and the second hole channel 22 can be increased, thereby improving stability of bonding between the solder strip 20 and the solar cell 10 at the first hole channel 21 and the second hole channel 22.

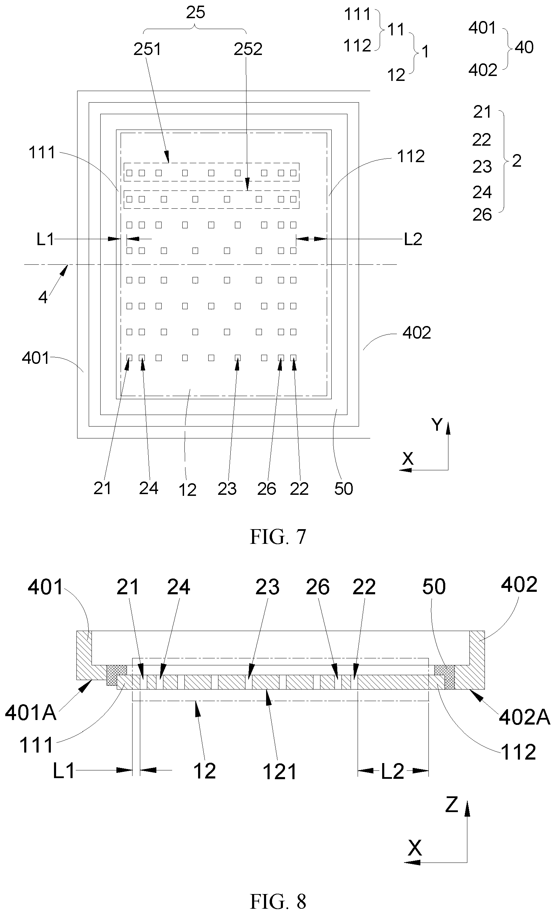

In another possible design, as shown in FIG. 7, the mesh holes 2 further include a fourth hole channel 24. Along the first direction X, the fourth hole channel 24 is located on a side of the glue printing region 12 close to the first portion 401, the fourth hole channel 24 is located between the first hole channel 21 and the second hole channel 22, and the third hole channels 23 are located between the fourth hole channel 24 and the second hole channel 22. The length of the first hole channel 21 in the first direction X ranges from 0.2 mm to 0.4 mm, the length of the first hole channel 21 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; a length of the fourth hole channel 24 in the first direction X ranges from 0.2 mm to 0.4 mm, and the length of the fourth hole channel 24 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like. And/or, the mesh holes 2 further include a fifth hole channel 26. Along the first direction X, the fifth hole channel 26 is located on a side of the glue printing region 12 close to the second portion 402, the fifth hole channel 26 is located between the first hole channel 21 and the second hole channel 22, and the third hole channels 23 are located between the fifth hole channel 26 and the first hole channel 21. A length of the second hole channel 22 in the first direction X ranges from 0.2 mm to 0.4 mm, the length of the second hole channel 22 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like; and a length of the fifth hole channel 26 in the first direction X ranges from 0.2 mm to 0.4 mm, and the length of the fifth hole channel 26 in the first direction X may be 0.2 mm, 0.21 mm, 0.23 mm, 0.25 mm, 0.27 mm, 0.29 mm, 0.3 mm, 0.31 mm, 0.33 mm, 0.35 mm, 0.37 mm, 0.39 mm, 0.4 mm, or the like.

The length of the first hole channel 21 ranges from 0.2 mm to 0.4 mm, the length of the fourth hole channel 24 ranges from 0.2 mm to 0.4 mm, the length of the second hole channel 22 ranges from 0.2 mm to 0.4 mm, and the length of the fifth hole channel 26 ranges from 0.2 mm to 0.4 mm. That is, one longer hole channel of 6 mm to 9 mm is changed to be two shorter hole channels of 0.2 mm to 0.4 mm, which can reduce the amount of glue output at the edge without changing the stability of bonding between the solder strip 20 and the solar cell 10, thereby reducing the glue printing cost of the solar cell 10.

A length of the third hole channel 23 in the first direction X ranges from 5 mm to 20 mm, which may be, for example, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or the like.

In any one of the embodiments described above, a width dimension of the mesh hole 2 in the second direction Y may range from 1 mm to 1.4 mm, which may be, for example, 1 mm, 1.01 mm, 1.03 mm, 1.05 mm, 1.07 mm, 1.09 mm, 1.1 mm, 1.11 mm, 1.13 mm, 1.15 mm, 1.17 mm, 1.19 mm, 1.2 mm, 1.21 mm, 1.23 mm, 1.25 mm, 1.27 mm, 1.29 mm, 1.3 mm, 1.31 mm, 1.33 mm, 1.35 mm, 1.37 mm, 1.39 mm, 1.4 mm, or the like.

During the glue printing of the solar cell 10 by the glue printing device, since the distance between two adjacent solar cells 10 in the first direction X is smaller, taking the second solar cell 10 as an example, when the glue printing device performs a glue printing operation on the second solar cell 10, there is a risk of abutment of the glue printing mesh 80 against the first solar cell 10, thereby leading to a risk of reduction in the amount of glue caused by adhesion of uncured glue on the first cell 10 to the glue printing mesh 80, that is, a risk of glue rubbing of the glue printing mesh 80. At the same time, during the subsequent glue printing, there is also a risk of damage to the solar cell 10 caused by abutment of the glue adhered to the glue printing mesh 80 against the solar cell 10.

To this end, a protruding portion may be provided on the mesh body 1. The protruding portion is configured to abut against the solar cell 10, and there is a certain height difference between the protruding portion and the frame, thereby reducing a risk of glue rubbing of the frame.

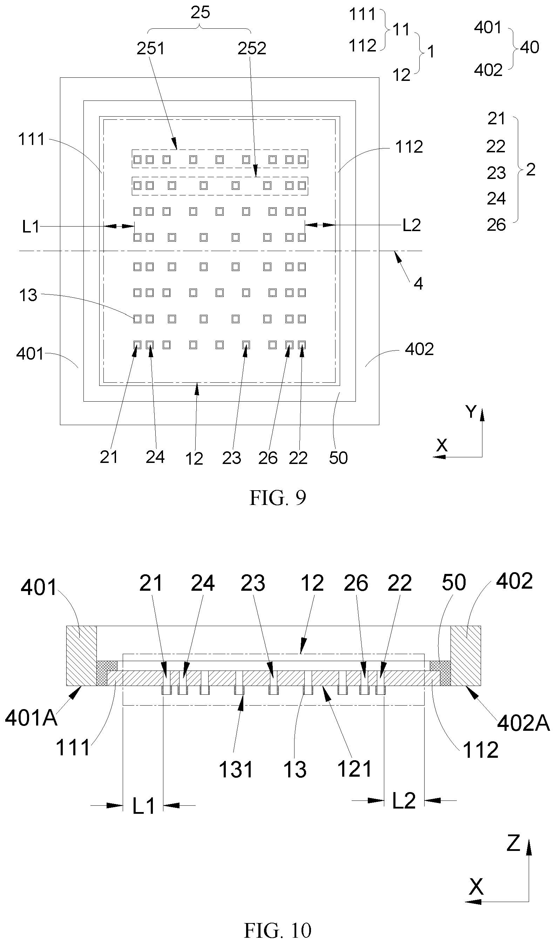

The protruding portion has two structural forms. In a possible design, as shown in FIG. 6, the mesh body 1 sinks and is bonded to the outer frame 40, i.e., along the third direction Z, a bonding position of the mesh body 1 on the outer frame 40 is lower, so that part of the glue printing region 12 protrudes from the outer frame 40 to form the protruding portion. This structural form simplifies the structure of the mesh body 1, thereby helping to reduce a processing cost and processing difficulty of the mesh body 1. In another possible design, as shown in FIG. 9 and FIG. 10, the mesh body 1 includes a protruding rib 13. Along the third direction Z, the protruding rib 13 is located at a side of the glue printing region 12 close to the solar cell 10, and the mesh holes 2 run through the glue printing region 12 and the protruding rib 13. The protruding rib 13 is the protruding portion mentioned above. By arranging the protruding rib 13 to form the protruding portion, a risk of glue rubbing of the glue printing mesh 80 can be reduced, so that a third surface 121 of the glue printing region 12 and a first surface 401A and a second surface 402A of the outer frame 40 are located in a same plane, thereby increasing a bonding area between the mesh body 1 and the outer frame 40, thus helping to improve stability and reliability of the bonding between the mesh body 1 and the outer frame 40.

When the mesh body 1 sinks and is bonded to the outer frame 40, as shown in FIG. 5 and FIG. 6, along the first direction X, at a side close to the first portion 401, a distance L1 between the first hole channel 21 and an edge of the glue printing region 12 satisfies 2 mm≤L1≤7 mm. For example, L1 may be 2 mm, 2.1 mm, 2.3 mm, 2.5 mm, 2.7 mm, 2.9 mm, 3 mm, 3.1 mm, 3.3 mm, 3.5 mm, 3.7 mm, 3.9 mm, 4 mm, 4.1 mm, 4.3 mm, 4.5 mm, 4.7 mm, 4.9 mm, 5 mm, 5.1 mm, 5.3 mm, 5.5 mm, 5.7 mm, 5.9 mm, 6 mm, 6.1 mm, 6.3 mm, 6.5 mm, 6.7 mm, 6.9 mm, 7 mm, or the like. As shown in FIG. 5 and FIG. 6, along the first direction X, at a side close to the second portion 402, a distance L2 between the second hole channel 22 and an edge of the glue printing region 12 satisfies 2 mm≤L2≤7 mm. For example, L2 may be 2 mm, 2.1 mm, 2.3 mm, 2.5 mm, 2.7 mm, 2.9 mm, 3 mm, 3.1 mm, 3.3 mm, 3.5 mm, 3.7 mm, 3.9 mm, 4 mm, 4.1 mm, 4.3 mm, 4.5 mm, 4.7 mm, 4.9 mm, 5 mm, 5.1 mm, 5.3 mm, 5.5 mm, 5.7 mm, 5.9 mm, 6 mm, 6.1 mm, 6.3 mm, 6.5 mm, 6.7 mm, 6.9 mm, 7 mm, or the like. Alternately, as shown in FIG. 7 and FIG. 8, 60 mm≤L2≤65 mm. For example, L2 may be 60 mm, 60.1 mm, 60.3 mm, 60.5 mm, 60.7 mm, 60.9 mm, 61 mm, 61.1 mm, 61.3 mm, 61.5 mm, 61.7 mm, 61.9 mm, 62 mm, 62.1 mm, 62.3 mm, 62.5 mm, 62.7 mm, 62.9 mm, 63 mm, 63.1 mm, 63.3 mm, 63.5 mm, 63.7 mm, 63.9 mm, 64 mm, 64.1 mm, 64.3 mm, 64.5 mm, 64.7 mm, 64.9 mm, 65 mm, or the like.

If L1<2 mm, the distance between the mesh hole 2 and the edge of the glue printing region 12 is small, so that a degree of deformation of the mesh body 1 here is weak, and the required downward pressing force of the scraper 90 is large, thereby increasing the difficulty of debugging of the downward pressing force of the glue printing device. If L1>7 mm, the distance between the mesh hole 2 and the edge of the glue printing region 12 is large, there is a risk of contact of the third surface 121 with uncured glue on the adjacent solar cell 10. Therefore, when 2 mm≤L1≤7 mm, the difficulty of debugging of the downward pressing force of the glue printing device is reduced, and a risk of glue scraping of the third surface 121 is reduced, thereby increasing a processing yield of the photovoltaic module.

If 2 mm≤L2≤7 mm, an overall dimension of the mesh body 1 in the first direction X is smaller, thereby helping to reduce a material cost of the mesh body 1. At the same time, L2 is smaller, which reduces a risk of abutment of the third surface 121 against the adjacent solar cell 10 that has not been glue-printed, thereby reducing a risk of damage to the solar cell 10 that has not been glue-printed caused by the third surface 121, so as to increase a yield of the photovoltaic module.

If 60 mm≤L2≤65 mm, the downward pressing force required for the scraper 90 here is reduced, thereby reducing the difficulty of debugging of the downward pressing force of the glue printing device. At the same time, the downward pressing force of the scraper 90 is smaller, which reduces glue output at the outermost mesh hole 2 at a side close to the second portion 402 and reduces a risk of a larger shielding area of the solar cell 10 caused by overflowing of a large amount of glue, thereby helping to improve photoelectric conversion efficiency of the solar cell 10. In addition, after the scraper 90 passes through the last one mesh hole 2, a movement distance of the scraper 90 in the first direction X is increased, which reduces a risk of damage to the scraper 90 caused by abutment of the scraper 90 against the outer frame 40, thereby prolonging the service life of the scraper 90 and the outer frame 40.

When 2 mm≤L1≤7 mm, in a plane defined by the first direction X and the third direction Z, a cross-sectional profile of the first portion 401 of the outer frame 40 is L-shaped, so that an avoidance region is formed at a side of the first portion 401 close to the scraper 90, which reduces a risk of damage caused by abutment of the scraper 90 against the first portion 401, thereby prolonging the service life of the outer frame 40.

When 2 mm≤L2≤7 mm, in the plane defined by the first direction X and the third direction Z, a cross-sectional profile of the second portion 402 of the outer frame 40 is L-shaped, so that an avoidance region is formed at a side of the second portion 402 close to the scraper 90, which reduces a risk of damage caused by abutment of the scraper 90 against the second portion 402, thereby prolonging the service life of the outer frame 40. When 2 mm≤L1≤7 mm and 2 mm≤L2≤7 mm, a dimension of the entire glue printing region 12 in the first direction X ranges from 90 mm to 100 mm, and the dimension of the glue printing region 12 in the first direction X complies with a dimension of the solar cell 10 in the first direction X.

When 60 mm≤L2≤65 mm, in the plane defined by the first direction X and the third direction Z, a cross-sectional profile of the second portion 402 of the outer frame 40 may be rectangular or L-shaped. The cross-sectional profile of the second portion 402 being rectangular can reduce processing difficulty and a processing cost of the outer frame 40, and the cross-sectional profile of the second portion 402 being L-shaped reduces a risk of damage caused by abutment of the scraper 90 against the second portion 402, thereby prolonging the service life of the scraper 90 and the outer frame 40. When 2 mm≤L1≤7 mm and 60 mm≤L2≤65 mm, the dimension of the entire glue printing region 12 in the first direction X ranges from 140 mm to 145 mm.

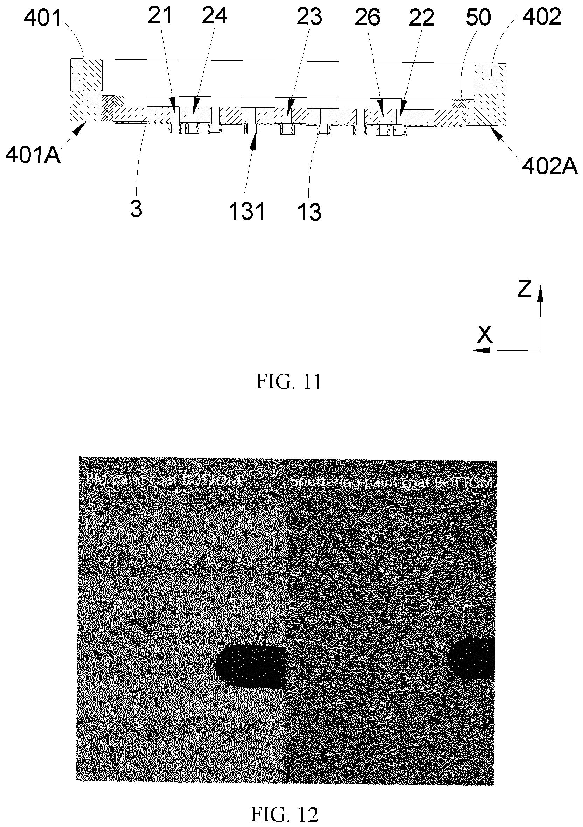

In any one of the embodiments described above, as shown in FIG. 11, the third surface 121 is covered by a hydrophobic coating 3. During the manufacturing of the mesh body 1, by magnetron sputtering, a device such as a vacuum furnace is used to enrich niobium pentoxide, silicon oxide, aluminum oxide, and fluoride onto the third surface 121 to form the hydrophobic coating 3, and a contact angle between the glue and the third surface 121 is increased. Compared with the BM coating formed by enriching fluoride onto the third surface 121 by physical infiltration in the prior art, as shown in FIG. 12, the hydrophobic coating 3 formed by magnetron sputtering in the present disclosure has low surface roughness, thereby reducing a residual amount of the glue on the third surface 121, so that a cleaning cycle of the third surface 121 is increased to 6 h to 8 h for one cleaning, which prolongs the cleaning cycle of the glue printing mesh 80, thereby reducing a number of cleanings and improving glue printing efficiency of the glue printing device.

A thickness of the hydrophobic coating 3 ranges from 80 nm to 120 nm, for example, 80 mm, 85 mm, 90 mm, 95 mm, 100 mm, 105 mm, 110 mm, 115 mm, 120 nm, or the like, to reduce manufacturing difficulty and a material cost of the hydrophobic coating 3.

When the mesh body 1 is provided with a protruding rib 13 and the protruding rib 13 is used as the protruding portion, as shown in FIG. 9 and FIG. 10, along the first direction X, at a side close to the first portion 401, the distance L1 between the mesh hole 2 and the edge of the glue printing region 12 satisfies 60 mm≤L1≤65 mm, for example, L1 may be 60 mm, 60.1 mm, 60.3 mm, 60.5 mm, 60.7 mm, 60.9 mm, 61 mm, 61.1 mm, 61.3 mm, 61.5 mm, 61.7 mm, 61.9 mm, 62 mm, 62.1 mm, 62.3 mm, 62.5 mm, 62.7 mm, 62.9 mm, 63 mm, 63.1 mm, 63.3 mm, 63.5 mm, 63.7 mm, 63.9 mm, 64 mm, 64.1 mm, 64.3 mm, 64.5 mm, 64.7 mm, 64.9 mm, 65 mm, or the like; and along the first direction X, at a side close to the second portion 402, the distance L2 between the mesh hole 2 and the edge of the glue printing region 12 satisfies 60 mm≤L2≤65 mm, for example, L2 may be 60 mm, 60.1 mm, 60.3 mm, 60.5 mm, 60.7 mm, 60.9 mm, 61 mm, 61.1 mm, 61.3 mm, 61.5 mm, 61.7 mm, 61.9 mm, 62 mm, 62.1 mm, 62.3 mm, 62.5 mm, 62.7 mm, 62.9 mm, 63 mm, 63.1 mm, 63.3 mm, 63.5 mm, 63.7 mm, 63.9 mm, 64 mm, 64.1 mm, 64.3 mm, 64.5 mm, 64.7 mm, 64.9 mm, 65 mm, or the like.

When 60 mm≤L1≤65 mm and 60 mm≤L2≤65 mm, the downward pressing force required for the scraper 90 at the edge of the glue printing region 12 is reduced, thereby reducing the difficulty of debugging of the downward pressing force of the glue printing device. At the same time, the downward pressing force of the scraper 90 is smaller, which reduces glue output at the mesh hole 2 close to the edge of the glue printing region 12 and reduces a risk of a larger shielding area of the solar cell 10 caused by overflowing of a large amount of glue, thereby helping to improve photoelectric conversion efficiency of the solar cell 10. In addition, in the first direction X, a movement space of the scraper 90 at edges at two sides of the glue printing region 12 is increased, which reduces a risk of damage to the scraper 90 caused by abutment of the scraper 90 against the outer frame 40, thereby prolonging the service life of the scraper 90 and the outer frame 40.

A surface of the protruding rib 13 for abutting against the solar cell 10 is a fourth surface 131. In a possible design, only the fourth surface 131 is covered by the hydrophobic coating 3 formed by magnetron sputtering, thereby reducing a residual amount of the glue on the fourth surface 131, so that a cleaning cycle of the fourth surface 131 is increased to 6 h to 8 h for one cleaning, which prolongs the cleaning cycle of the glue printing mesh 80, thereby reducing a number of cleanings and improving glue printing efficiency of the glue printing device.

In a possible design, each of the third surface 121 and the fourth surface 131 is covered by the hydrophobic coating 3 formed by magnetron sputtering, thereby reducing residual amounts of the glue on the third surface 121 and the fourth surface 131, so that cleaning cycles of the third surface 121 and the fourth surface 131 are increased to 6 h to 8 h for one cleaning, which prolongs the cleaning cycle of the glue printing mesh 80, thereby reducing a number of cleanings and improving glue printing efficiency of the glue printing device.

In any one of the embodiments described above, an overall dimension of the glue printing region 12 in the second direction Y ranges from 300 mm to 400 mm, which may be, for example, 300 mm, 310 mm, 320 mm, 330 mm, 340 mm, 350 mm, 360 mm, 370 mm, 380 mm, 390 mm, 400 mm, or the like; and in the second direction Y, the distance between the outermost mesh hole 2 and the edge of the glue printing region 12 ranges from 70 mm to 80 mm, which may be, for example, 71 mm, 72 mm, 73 mm, 74 mm, 75 mm, 76 mm, 77 mm, 78 mm, 79 mm, 80 mm, or the like.

In a possible design, as shown in FIG. 4, one glue printing mesh 80 may cover one solar cell 10. That is, the glue printing mesh 80 is provided with only one glue printing region 12, so as to reduce the overall dimension of the glue printing mesh 80.

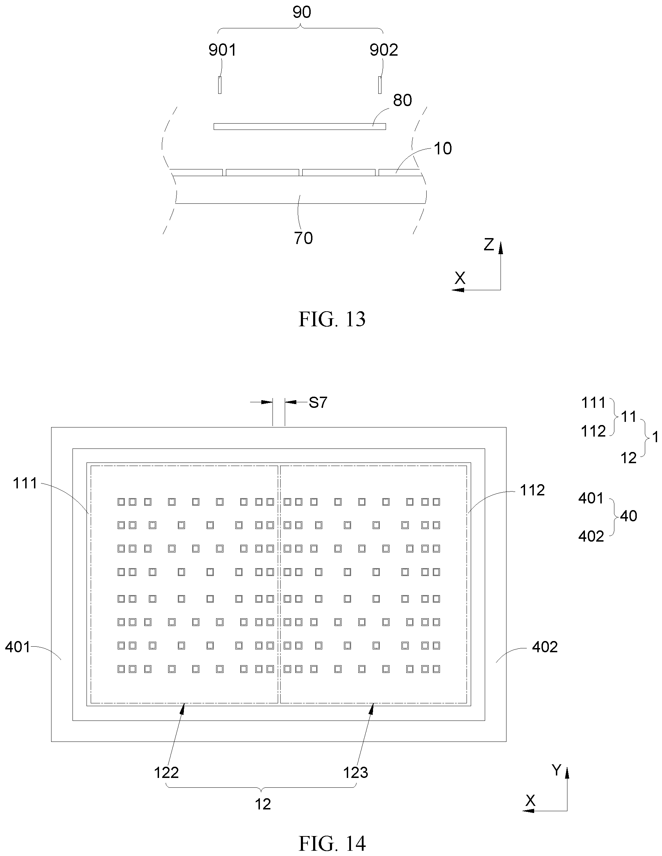

In another possible design, as shown in FIG. 13, one glue printing mesh 80 may cover at least two solar cells 10. That is, as shown in FIG. 14, the glue printing region 12 includes at least a third region 122 and a fourth region 123 distributed along the first direction X, and the third region 122 and the fourth region 123 correspond to adjacent solar cells 10. When the glue printing device performs a glue printing operation, During one glue printing stroke, the glue printing device can glue-print two solar cells 10 at the same time, so as to improve glue printing efficiency of the glue printing device, thereby facilitating the cooperative use of the glue printing device and a high-speed soldering machine.

A minimum distance S7 between the second hole channel 22 in the third region and the first hole channel 21 in the fourth region satisfies 15 mm≤S7≤25 mm, which may be, for example, 15 mm, 16 mm, 17 mm, 18 mm, 19 mm, 20 mm, 21 mm, 22 mm, 23 mm, 24 mm, 25 mm, or the like.

If S7<15 mm, strength of the mesh body 1 between the second hole channel 22 in the third region and the first hole channel 21 in the fourth region is weak, and there is a risk of damage to the mesh body when the scraper 90 presses down. If S7>25 mm, the overall dimension of the mesh body 1 is increased, thereby increasing the cost of the glue printing device, at the same time, there is a higher risk of deviation of relative positions of the fourth region 123 and the solar cell 10. Therefore, when 15 mm≤S7≤25 mm, strength of the mesh body 1 is improved, thereby prolonging the service life of the glue printing device, at the same time, accuracy of the relative positions of the fourth region 123 and the solar cell 10 is improved.

In a third aspect, some embodiments of the present disclosure provide a glue printing process of a photovoltaic module. The photovoltaic module is the photovoltaic module in any one of the embodiments described above. The glue printing device is the glue printing device in any one of the embodiments described above. The glue printing process of a photovoltaic module includes: arranging a plurality of solar cells at intervals along the first direction X, and placing the solder strip on the plurality of solar cells; pre-soldering the plurality of solar cells and the solder strip at solder points to form a pre-fixed solar cell string; and placing the pre-fixed solar cell string on a glue printing device, the glue printing device being the glue printing device in any one of the embodiments, and the glue printing device printing glue on a surface where the pre-fixed solar cell string is placed to form the glue dots described above.

The process of the glue printing device printing glue on a surface where the pre-fixed solar cell string is placed to form the glue dots described above includes: placing the pre-fixed solar cell string on a base, the pre-fixed solar cell string being located between the glue printing mesh and the base along a third direction Z; moving the glue printing mesh along the third direction Z to cause a surface of the glue printing mesh to contact the solder strip; moving a scraper along the third direction Z to make the scraper abut against a surface of the glue printing mesh facing away from the solar cells, in such a manner that the glue printing mesh is driven by the scraper to partially deform towards the solar cells; moving the scraper along the first direction X, in such a manner that the glue is driven by the scraper to flow through mesh holes to reach surfaces of the solder strip and the solar cells; after the scraper completes one printing stroke, moving the scraper and the glue printing mesh along the third direction Z towards a direction away from the solar cells; and moving the pre-fixed solar cell string to a curing device, to facilitate curing of the glue to form the glue dots 60.

When one glue printing mesh 80 covers at least two solar cells 10, the process of moving the scraper along the first direction X, in such a manner that the glue is driven by the scraper to flow through mesh holes to reach surfaces of the solder strip and the solar cells includes: moving the scraper from the connection region to the third region along the first direction X and continuously moving the scraper, in such a manner that the glue flows through the mesh holes in the third region to reach the surfaces of the solder strip and the first solar cell; and moving the scraper from the third region to the fourth region along the first direction X and continuously moving the scraper, in such a manner that the glue flows through the mesh holes in the fourth region to reach the surfaces of the solder strip and the second solar cell.

The above are merely preferred embodiments of the present disclosure and are not intended to limit the present disclosure. For those skilled in the art, various modifications and variations may be made to the present disclosure. Any modifications, equivalent replacements, improvements, and the like made within a spirit and a principle of the present disclosure shall fall within a scope of the present disclosure.

## Claims

1. A photovoltaic module, comprising a solar cell string (300), wherein the solar cell string (300) comprises solar cells (10), solder strips (20), and glue dots (60),
wherein adjacent solar cells (10) are electrically connected to each other through the solder strips (20), the solder strips (20) each extend along a first direction (X), the solder strips (20) are arranged at intervals along a second direction (Y), the solar cells (10) are provided with solder points (30), the solar cells (10) and the solder strips (20) are soldered and fixed at the solder points (30), a part of at least one of the glue dots (60) is located on a surface of one of the solar cells (10) and another part of the at least one of the glue dots (60) is located on a surface of one of the solder strips (20), in such a manner that the solar cells (10) and the solder strips (20) are bonded and fixed at the glue dots (60), and a plurality of glue dots (60) of the glue dots (60) are arranged along the first direction (X);
wherein the solder points (30) comprise a first solder point (301) and a second solder point (302), and along the first direction (X), the first solder point (301) and the second solder point (302) are located on two sides of one of the solar cells (10), and at least one of the glue dots (60) is located between the first solder point (301) and the second solder point (302); and
wherein the solder strips (20) comprise at least a first solder strip and a second solder strip arranged along the second direction (Y), and at least one of the glue dots (60) on the first solder strip is not aligned with at least one of the glue dots (60) on the second solder strip in the second direction (Y).

2. The photovoltaic module according to claim 1, wherein along the first direction (X), at least part of the glue dots (60) is located a side of the first solder point (301) facing away from the second solder point (302).

3. The photovoltaic module according to claim 2, wherein a distance S5 between the first solder point (301)and the at least part of the glue dots (60) that is located a side of the first solder point (301) facing away from the second solder point (302) satisfies 1 mm≤S5≤2 mm.

4. The photovoltaic module according to claim 1, wherein along the first direction (X), at least part of the glue dots (60) is located a side of the second solder point (302) facing away from the first solder point (301).

5. The photovoltaic module according to claim 4, wherein a distance S6 between the second solder point (302) and the at least part of the glue dots (60) that is located a side of the second solder point (302) facing away from the first solder point (301) satisfies 1 mm≤S5≤2 mm.

6. The photovoltaic module according to claim 1, wherein the first solder points (301) on adjacent solder strips (20) are directly opposite to each other in the second direction (Y), and the second solder points (302) on adjacent solder strips (20) are directly opposite to each other in the second direction (Y).

7. The photovoltaic module according to claim 6, wherein the glue dots (60) comprise at least a first glue dot (601), a second glue dot (602), and third glue dots (603), and wherein
in the first direction (X), the third glue dots (603) are arranged at intervals and located between the first glue dot (601) and the second glue dot (602);
in the first direction (X), the first glue dot (601) is located at a side of the first solder point (301) facing away from the second solder point (302), or the first glue dot (601) is located between the first solder point (301) and the second solder point (302); or in a third direction (Z) perpendicular to both the first direction (X) and the second direction (Y), at least part of the first glue dot (601) is located above the first solder point (301); and/or
in the first direction (X), the second glue dot (602) is located at a side of the second solder point (302) facing away from the first solder point (301), or the second glue dot (602) is located between the first solder point (301) and the second solder point (302); or in a third direction (Z) perpendicular to both the first direction (X) and the second direction (Y), at least part of the second glue dot (602) is located above the second solder point (302).

8. The photovoltaic module according to claim 7, wherein
the first glue dot (601) on the first solder strip is directly opposite to the first glue dot (601) on the second solder strip in the second direction (Y), and/or the second glue dot (602) on the first solder strip is directly opposite to the second glue dot (602) on the second solder strip in the second direction (Y);
the third glue dots (603) on the first solder strip are not aligned with the third glue dots (603) on the second solder strip in the second direction (Y); and
the third glue dots (603) are evenly arranged between the first glue dot (601) and the second glue dot (602).

9. The photovoltaic module according to claim 8, wherein a number N1 of the third glue dots (603) arranged in the first direction (X) satisfies 4≤N1≤21.

10. The photovoltaic module according to claim 9, wherein a length of the first glue dot (601) in the first direction (X) ranges from 6 mm to 9 mm.

11. The photovoltaic module according to claim 9, wherein a length of the second glue dot (602) in the first direction (X) ranges from 6 mm to 9 mm.

12. The photovoltaic module according to claim 9,
wherein the glue dots (60) further comprise a fourth glue dot (604), and in the first direction (X), the fourth glue dot (604) is located between the first glue dot (601) and the second glue dot (602), and the third glue dots (603) are located between the fourth glue dot (604) and the second glue dot (602); and wherein a length of the first glue dot (601) in the first direction (X) ranges from 0.2 mm to 0.4 mm, a length of the fourth glue dot (604) in the first direction (X) ranges from 0.2 mm to 0.4 mm, and a distance between the first glue dot (601) and the fourth glue dot (604) in the first direction (X) ranges from 6 mm to 9 mm.

13. The photovoltaic module according to claim 9,
wherein the glue dots (60) further comprise a fifth glue dot (605), and in the first direction (X), the fifth glue dot (605) is located between the first glue dot (601) and the second glue dot (602), and the third glue dots (603) are located between the first glue dot (601) and the fifth glue dot (605); and wherein a length of the second glue dot (602) in the first direction (X) ranges from 0.2 mm to 0.4 mm, a length of the fifth glue dot (605) in the first direction (X) ranges from 0.2 mm to 0.4 mm, and a distance between the second glue dot (602) and the fifth glue dot (605) in the first direction (X) ranges from 6 mm to 9 mm.

14. The photovoltaic module according to any one of claims 2 to 13,
wherein a number N2 of the solder strips (20) arranged in the second direction (Y) satisfies 14≤N2≤16;
in the first direction (X), a distance S1 between the first solder point (301) and an edge of the solar cell (10) satisfies 7 mm≤S1≤8 mm;
in the second direction (Y), a distance S2 between the first solder point (301) and an edge of the solar cell (10) satisfies 7 mm≤S2≤8 mm; and/or
in the first direction (X), a distance S3 between the second solder point (302) and an edge of the solar cell (10) satisfies 7 mm≤S3≤8 mm;
in the second direction (Y), a distance S4 between the second solder point (302) and an edge of the solar cell (10) satisfies 7 mm≤S4≤8 mm.

15. The photovoltaic module according to any one of claims 6 to 13, wherein
in the first direction (X), the first glue dot (601) is located at a side of the first solder point (301) facing away from the second solder point (302), or the first glue dot (601) is located between the first solder point (301) and the second solder point (302), and a distance S5 between the first glue dot (601) and the first solder point (301) satisfies 1 mm≤S5≤2 mm; and/or
in the first direction (X), the second glue dot (602) is located at a side of the second solder point (302) facing away from the first solder point (301), or the second glue dot (602) is located between the first solder point (301) and the second solder point (302), and a distance S6 between the second glue dot (602) and the second solder point (302) satisfies 1 mm≤S6≤2 mm.
